# EUROPÄISCHE PATENTSCHRIFT

(11) **EP 1 132 750 B1**
(45) Veröffentlichungstag und Bekanntmachung des Hinweises auf die Patenterteilung: **11.06.2008**
(21) Anmeldenummer: 00128175.7
(22) Anmeldetag: 21.12.2000
(51) Int. Cl.: G01R 31/3185, G06F 11/267, G01R 31/317

(54) **Elektrische Schaltung und Verfahren zum Testen einer Schaltungskomponente der elektrischen Schaltung**
Electrical circuit and method for testing a component of the electrical circuit
Circuit électrique et méthode de test d'un composant du circuit électrique

(30) Priorität: 26.01.2000 DE 10003260; 31.03.2000 DE 10016127
(43) Veröffentlichungstag der Anmeldung: 12.09.2001
(73) Patentinhaber: Infineon Technologies AG, 81669 München (DE)
(72) Erfinder: Plättner, Eckehard, 81737 München (DE); Täuber, Andreas, 85716 Unterschleissheim (DE); Nygren, Aaron, 81667 München (DE)
(74) Vertreter: Jannig, Peter

(56) Entgegenhaltungen:
- EP-A- 0 517 269
- US-A- 5 136 185
- US-A- 5 841 968

## Beschreibung

Die vorliegende Erfindung betrifft eine Vorrichtung gemäß dem Oberbegriff des Patentanspruchs 1 und ein Verfahren gemäß dem Oberbegriff des Patentanspruchs 20, d. h.
- eine elektrische Schaltung mit über einen Bus verbundenen Schaltungskomponenten, wobei wenigstens eine der Schaltungskomponenten unabhängig von den anderen Schaltungskomponenten testbar ist, und
- ein Verfahren zum Testen einer Schaltungskomponente, die über einen Bus mit anderen Schaltungskomponenten verbunden ist, wobei die zu testende Schaltungskomponente unabhängig von den anderen Schaltungskomponenten testbar ist.

Die zu testende Schaltungskomponente ist beispielsweise ein sogenanntes Makro einer integrierten Schaltung. Beim Testen einer integrierten Schaltung müssen oder sollen bestimmte Makros einzeln, d. h. unabhängig von den anderen Schaltungskomponenten der integrierten Schaltung getestet werden.

Obgleich bei solchen Tests nur ein relativ kleiner Teil der integrierten Schaltung getestet wird, sind solche Tests insbesondere wegen der sehr hohen Ströme, die während des Testens durch die integrierte Schaltung fließen können, und wegen der damit verbundenen extremen Wärmeentwicklung häufig relativ aufwendig. Mitunter werden aus den genannten Gründen auch Testergebnisse erhalten, die nicht der Realität entsprechen.

In der EP 0 517 269 A sind eine elektrische schaltung gemäß dem Oberbegriff des Patentanspruchs 1 und ein Verfahren gemäß dem Oberbegriff des Patentanspruchs 20 beschrieben, bei welchen während des Testens eines Bus-Controllers eine "operation unit", welche an dem durch den Bus-Controller zu steuernden Bus angeschlossen ist, so angesteuert wird, daß sie keine Daten auf den Bus ausgibt. Hierdurch lassen sich die vorstehend genannten Probleme jedoch nicht oder nur teilweise lösen.

Der vorliegenden Erfindung liegt daher die Aufgabe zugrunde, die Vorrichtung gemäß dem Oberbegriff des Patentanspruchs 1 und das Verfahren gemäß dem Oberbegriff des Patentanspruchs 20 derart weiterzubilden, daß sich zu testende Schaltungskomponenten mit minimalem Aufwand zuverlässig testen lassen.

Diese Aufgabe wird durch die in Patentanspruch 1 beanspruchte Schaltung bzw. durch das in Patentanspruch 20 beanspruchte Verfahren gelöst.

Die erfindungsgemäße Schaltung und das erfindungsgemäße Verfahren zeichnen sich dadurch aus,
- daß die wenigstens eine Schaltungskomponente, die unabhängig von den anderen Schaltungskomponenten testbar ist, während des Testens der wenigstens einen Schaltungskomponente, keine Daten auf den Bus ausgibt oder anstelle der Daten, die im normalen Betrieb auf den Bus auszugeben wären, andere Daten auf den Bus ausgibt, bzw.
- daß dafür gesorgt wird, daß die zu testende Schaltungskomponente während des Testens der zu testenden Schaltungskomponente keine Daten auf den Bus ausgibt oder anstelle der Daten, die im normalen Betrieb auf den Bus auszugeben wären, andere Daten auf den Bus ausgibt.

Durch Vorsehen dieser Merkmale kann erreicht werden, daß die Ausgangstreiber der zu testenden Schaltungskomponente während des Testens derselben überhaupt keine Energie oder nur sehr wenig Energie verbrauchen. Dies ist für den Fall, daß durch die zu testende Schaltungskomponente keine Daten auf den Bus ausgegeben werden, einleuchtend, gilt aber auch für den Fall, daß Daten auf den Bus ausgegeben werden. Die Daten, die - wenn überhaupt - während des Testens der zu testenden Schaltungskomponente durch diese auf den Bus ausgegeben werden, sind nämlich nicht die Daten, die die betreffende Schaltungskomponente während des normalen Betriebes auf den Bus ausgeben würde, und können daher so gewählt und ausgegeben werden, daß der Energieverbrauch der Ausgangstreiber minimal ist.

Die Ausgangstreiber haben unter anderem dann einen geringen Energieverbrauch, wenn sich die auf den Bus auszugebenden Daten nicht oder nur selten ändern. Dies liegt daran, daß in diesem Fall die Busleitungen, welche eine beträchtliche Kapazität aufweisen können, und deren Umladen insbesondere bei hohen Taktfrequenzen relativ große Ströme erfordern kann, nicht oder nur selten umgeladen werden müssen. Das selten oder überhaupt nicht erforderliche Umladen der Busleitungen hat den positiven Effekt, daß die Ausgangstreiber nie oder nur selten große Ströme liefern müssen. Dies wiederum bewirkt, daß die betreffende Schaltungskomponente beim Testen bei weitem nicht so heiß wird wie es ohne die beanspruchten Maßnahmen der Fall wäre.

Ein geringer Energieverbrauch der Ausgangstreiber und die damit verbundenen Vorteile können auch dadurch erreicht werden, daß zusätzlich oder alternativ vorgesehen wird, die Ausgabe der auf den Bus auszugebenden Daten während des Testens unter Umgehung der Ausgangstreiber erfolgen zu lassen; die Ausgangstreiber können dann während des Testens abgeschaltet oder deaktiviert werden.

Daß die zu testende Schaltungskomponente während des Testens derselben nicht die Daten auf den Bus ausgibt, die sie im Normalfall ausgibt, und/oder die auszugebenden Daten anders als im Normalfall ausgibt, beeinflußt das Testergebnis nicht. Die zu testenden Schaltungskomponente soll ja unabhängig von den anderen Schaltungskomponenten getestet werden, wodurch es nicht erforderlich ist, daß über den Bus ein Datenaustausch zwischen den Schaltungskomponenten der elektrischen Schaltung stattfindet.

Die beanspruchte Vorrichtung und das beanspruchte Verfahren ermöglichen es mithin, daß sich zu testende Schaltungskomponenten mit minimalem Aufwand zuverlässig testen lassen.

Vorteilhafte Weiterbildungen der Erfindung sind den Unteransprüchen, der folgenden Beschreibung, und den Figuren entnehmbar.

Die Erfindung wird nachfolgend anhand von Ausführungsbeispielen unter Bezugnahme auf die Figuren näher erläutert. Es zeigen
- Figur 1: ein erstes Ausführungsbeispiel der nachfolgend näher beschriebenen elektrischen Schaltung,
- Figur 2: ein zweites Ausführungsbeispiel der nachfolgend näher beschriebenen elektrischen Schaltung, und
- Figur 3: ein drittes Ausführungsbeispiel der nachfolgend näher beschriebenen elektrischen Schaltung, und

Die im folgenden beschriebene elektrische Schaltung ist eine integrierte Schaltung. Es sei jedoch bereits an dieser Stelle darauf hingewiesen, daß hierauf keine Einschränkung besteht. Bei der elektrischen Schaltung kann es sich auch um eine beliebige andere elektrische Schaltung handeln.

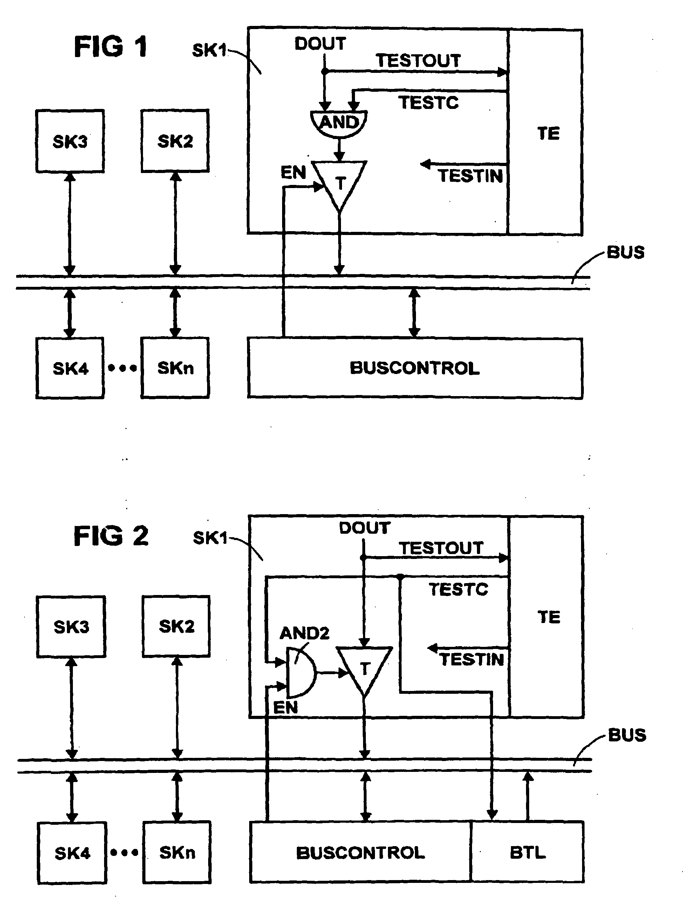

Ein erstes Ausführungsbeispiel der elektrischen Schaltung ist in Figur 1 dargestellt.

Die in der Figur 1 gezeigte elektrische Schaltung besteht aus Schaltungskomponenten (Makros) SK1, SK2, ... SKn, einem die Schaltungskomponenten SK1, SK2, ... SKn verbindenden Bus BUS, und einer die Steuerung (insbesondere die Arbitrierung) des Busses BUS übernehmenden Bus-Steuereinrichtung BUSCONTROL.

Unter den Schaltungskomponenten SK1, SK2, ... SKn befindet sich mindestens eine Schaltungskomponente, die einzeln, d. h. unabhängig von den anderen Schaltungskomponenten der elektrischen Schaltung getestet werden kann.

Bei dieser Schaltungskomponente handelt es sich im betrachteten Beispiel um die mit dem Bezugszeichen SK1 bezeichnete Schaltungskomponente.

Die Schaltungskomponente SK1 ist im betrachteten Beispiel ein Speichermodul, genauer gesagt ein DRAM-Makro. Es sei jedoch bereits an dieser Stelle darauf hingewiesen, daß hierauf keine Einschränkung besteht. Die wie nachfolgend beschrieben testbare Schaltungskomponente kann auch ein beliebiger anderer Schaltungsteil sein.

Zum Testen der Schaltungskomponente SK1 ist eine Testeinheit TE vorgesehen. Diese Testeinheit ist im betrachteten Beispiel Bestandteil der zu testende Schaltungskomponente SK1. Auch hierauf besteht jedoch keine Einschränkung. Die Testeinheit TE kann auch außerhalb der zu testenden Schaltungskomponente SK1 vorgesehen sein; sie kann dabei an beliebigen Stellen innerhalb der elektrischen Schaltung, aber auch außerhalb derselben vorgesehen sein.

Die Testeinheit TE
- koppelt Testdaten TESTIN in die zu testende Schaltungskomponente SK1 ein,
- koppelt Testdaten TESTOUT aus der zu testenden Schaltungskomponente SK1 aus,
- steuert die zu testende Schaltungskomponente SK1 durch ein Testkontrollsignal TESTC, und
- überprüft anhand der Testdaten TESTIN und TESTOUT, ob die zu testende Schaltungskomponente SK1 richtig arbeitet.

Im normalen Betrieb der Schaltungskomponente SK1, also wenn und so lange die Schaltungskomponente SK1 nicht getestet wird,
- werden der Schaltungskomponente SK1 über den Bus BUS und eine in der Figur 1 nicht gezeigte Datenempfangsvorrichtung Daten zugeführt, und
- gibt die Schaltungskomponente SK1 über eine Vielzahl von Ausgangstreibern, von welchen in der Figur 1 nur ein einziger Ausgangstreiber T gezeigt ist, Daten auf den Bus BUS aus.

Die Ausgangstreiber T sind im betrachteten Beispiel sogenannte Tri-State-Treiber und werden durch die Bus-Steuereinrichtung BUSCONTROL, genauer gesagt durch ein von dieser ausgegebenes Freigabesignal EN aktiviert bzw. deaktiviert. Wenn die Ausgangstreiber T aktiviert sind, was im betrachteten Beispiel bei EN=1 der Fall sein möge, geben sie die ihnen zugeführten Daten auf den Bus BUS aus. Wenn die Ausgangstreiber T deaktiviert sind, was im betrachteten Beispiel bei EN=0 der Fall sein möge, können sie keine Daten auf den Bus BUS ausgeben; sie befinden sich dann in einem hochohmigen Zustand.

Während des Testens der Schaltungskomponente SK1
- werden von der Schaltungskomponente SK1 anstelle der ihr über den Bus BUS zugeführten Daten die Testdaten TESTIN der Testeinheit TE verwendet,
- werden die normalerweise auf den Bus BUS ausgegebenen Daten als Testdaten TESTOUT der Testeinheit TE verwendet, und
- werden anstelle der normalerweise auf den Bus BUS ausgegebenen Daten andere Daten auf den Bus ausgegeben.

Die während des Testens der Schaltungskomponente SK1 auf den Bus BUS ausgegebenen Daten werden im betrachteten Beispiel unabhängig von den eigentlich auf den Bus auszugebenden Daten generiert; sie weisen die Besonderheit auf, daß sie sich nicht oder nur sehr selten ändern.

Im betrachteten Beispiel werden während des Testens der Schaltungskomponente SK1 dauerhaft den Pegel "0" repräsentierende Daten auf den Bus BUS ausgegeben.

Wann welche Daten auf den Bus BUS ausgegeben werden, wird im betrachteten Beispiel durch eine den Ausgangstreibern T vorgeschaltete Logik bestimmt.

Diese Logik besteht im betrachteten Beispiel aus einem UND-Glied AND, welches die im normalen Betrieb der Schaltungskomponente SK1 auf den Bus BUS auszugebenden Daten DOUT und das Testkontrollsignal TESTC als Eingangssignale erhält, und dessen Ausgangssignal dem Ausgangstreiber T als Eingangssignal zugeführt wird.

Das Testkontrollsignal TESTC hat im normalen Betrieb der Schaltungskomponente SK1 den Wert "1". Dies hat zur Folge, daß das Ausgangssignal des UND-Gliedes dem Eingangssignal DOUT des UND-Gliedes entspricht. Dadurch werden im normalen Betrieb der Schaltungskomponente SK1 die eigentlich auf den Bus BUS auszugebenden Daten DOUT auf den Bus ausgegeben.

Während des Testens der Schaltungskomponente SK1 hat das Testkontrollsignal den Wert "0". Dies hat zur Folge, daß das Ausgangssignal des UND-Gliedes unabhängig vom Wert des anderen Eingangssignals des UND-Gliedes den Wert "0" aufweist. Dadurch wird während des Testens der Schaltungskomponente SK1 dauerhaft der Wert "0" auf den Bus ausgegeben.

Daß während des Testens der Schaltungskomponente SK1 von dieser Daten auf den Bus BUS ausgegeben werden, die sich nie oder nur selten verändern, hat den positiven Effekt, daß die Busleitungen nie oder nur selten umgeladen werden müssen. Dies ist vorteilhaft, weil
- die Ausgangstreiber T dadurch nur relativ wenig Energie verbrauchen, und
- sich die Ausgangstreiber T und damit auch die Schaltungskomponente SK1 nicht übermäßig erhitzten.

Durch den geringen Energieverbrauch der elektrischen Schaltung während des Testens und die relativ niedrige Temperatur der elektrischen Schaltung während des Testens kann die zu testende Schaltungskomponente SK1 mit minimalem Aufwand zuverlässig getestet werden. Insbesondere ist es dadurch
- möglich, die Elemente (Nadeln), über welche die elektrische Schaltung während des Testens mit Energie versorgt wird, anzahl- und größenmäßig klein zu halten, und
- vergleichsweise einfach möglich, Tieftemperaturtests durchzuführen.

Daß während des Testens der Schaltungskomponente SK1 nicht die eigentlich auf den Bus BUS auszugebenden Daten DOUT, sondern andere Daten auf den Bus ausgegeben werden, hat keinen negativen Einfluß auf das Testergebnis. Die zu testende Schaltungskomponente SK1 soll ja unabhängig von den anderen Schaltungskomponenten der elektrischen Schaltung getestet werden, so daß es keine Rolle spielt, ob und gegebenenfalls welche Daten von der Schaltungskomponente SK1 auf den Bus ausgegeben werden.

Daß die Schaltungskomponente SK1 Daten auf den Bus BUS ausgibt, erweist sich aber dennoch als vorteilhaft. Würde die Schaltungskomponente SK1 ihre Ausgangstreiber während des Testens selbständig deaktivieren (in den hochohmigen Zustand versetzen), könnte dies zu Problemen führen. Im allgemeinen sollen (dürfen) nämlich nie oder allenfalls kurzzeitig gleichzeitig alle an den Bus BUS angeschlossenen Komponenten in den hochohmigen Zustand versetzte Ausgangstreiber aufweisen; der Bus BUS soll (muß) ständig durch genau eine der an ihn angeschlossenen Komponenten terminiert werden.

Dieses Problem tritt vorliegend jedoch nicht auf. Dadurch kann die Bus-Steuereinrichtung während des Testens der Schaltungskomponente SK1 unverändert weiterarbeiten und die alleinige Kontrolle über den Bus BUS behalten. Dies wiederum ermöglicht es, daß mehrere Schaltungskomponenten der elektrischen Schaltung gleichzeitig getestet werden können.

Es dürfte einleuchten, daß während des Testens der Schaltungskomponente SK1 nicht zwangsläufig dauerhaft den Pegel "0" repräsentierende Daten auf den Bus BUS ausgegeben werden müssen. Es können auch dauerhaft den Pegel,"1" repräsentierende Daten auf den Bus BUS ausgegeben werden. Es kann ferner vorgesehen werden, daß während des Testens der Schaltungskomponente SK1 Daten auf den Bus BUS ausgegeben werden, die nicht dauerhaft einen vorbestimmten Pegel aufweisen, sondern sich verändern; solange sich die auf den Bus ausgegebenen Daten nur relativ selten verändern, lassen sich damit im wesentlichen die selben vorteilhaften Effekte erzielen wie es bei der Ausgabe von sich nicht verändernden Daten auf den Bus der Fall ist.

Es dürfte ebenfalls einleuchten, daß die Logik, unter Verwendung welcher die auf den Bus auszugebenden Daten generiert werden, nicht zwangsläufig ein wie beschrieben ausgebildetes und angeordnetes UND-Glied AND sein muß. Hierzu gibt es zahllose weitere Möglichkeiten: beispielsweise kann statt des UND-Gliedes AND ein NAND-Glied verwendet werden, oder ein Multiplexer, über welchen wahlweise die im normalen Betrieb auszugebenden Daten DOUT oder während des Testens auszugebende Daten zum Ausgangstreiber T durchgeschaltet werden.

Die elektrische Schaltung kann aber auch so ausgebildet sein, daß die zu testende Schaltungskomponente während des Testens desselben keine Daten auf den Bus ausgibt.

Ein Ausführungsbeispiel einer solchen elektrischen Schaltung ist in Figur 2 dargestellt und wird nachfolgend unter Bezugnahme darauf beschrieben.

Die in der Figur 2 gezeigte elektrische Schaltung entspricht weitgehend der in der Figur 1 gezeigten elektrischen Schaltung. Sie (die in der Figur 2 gezeigte elektrische Schaltung) besteht wie die in der Figur 1 gezeigte elektrische Schaltung aus Schaltungskomponenten (Makros) SK1, SK2, ... SKn, einem die Schaltungskomponenten SK1, SK2, ... SKn verbindenden Bus BUS, und einer die Steuerung (insbesondere die Arbitrierung) des Busses BUS übernehmenden Bus-Steuereinrichtung BUSCONTROL. Von den vorhandenen Schaltungskomponenten SK1, SK2, ... SKn soll auch wieder die mit dem Bezugszeichen SK1 bezeichnete Schaltungskomponente einzeln, d. h. unabhängig von den anderen Schaltungskomponenten der elektrischen Schaltung getestet werden. Das Testen der zu testenden Schaltungskomponente erfolgt eine Testeinheit TE, die wie auch die in der elektrischen Schaltung gemäß Figur 1 vorgesehene Testeinheit TE in der zu testenden Schaltungskomponente, d. h. der Schaltungskomponente SK1 enthalten ist. Insoweit besteht zwischen der elektrischen Schaltung gemäß Figur 1 und der elektrischen Schaltung gemäß Figur 2 Übereinstimmung.

Im Unterschied zur Schaltungskomponente SK1 gemäß Figur 1 gibt die Schaltungskomponente SK2 gemäß Figur 2 während des Testens desselben jedoch keine Daten auf den Bus BUS aus.

Dies wird im betrachteten Beispiel dadurch erreicht, daß die (Steuer-)Anschlüsse der auch bei der Schaltungskomponente SK1 gemäß Figur 2 vorhandenen Ausgangstreiber T, über welche diese aktivierbar und deaktivierbar sind, nicht mehr mit dem von der Bus-Steuereinrichtung BUSCONTROL ausgegebenen FreigabeSignal EN, sondern mit dem Ausgangssignal einer dem Steueranschluß vorgeschalteten Logik beaufschlagt werden.

Diese Logik besteht im betrachteten Beispiel aus einem UND-Glied AND2, welches das Freigabesignal EN und das auch bei der elektrischen Schaltung gemäß Figur 2 vorgesehene Testkontrollsignal TESTC als Eingangssignale erhält, und dessen Ausgangssignal zur Steuerung der Ausgangstreiber T verwendet wird.

Das Testkontrollsignal TESTC hat im normalen Betrieb der Schaltungskomponente SK1 den Wert "1". Dies hat zur Folge, daß während des normalen Betriebes der Schaltungskomponente SK1 das Signal, unter Verwendung dessen die Ausgangstreiber gesteuert werden, dem Freigabesignal EN entspricht.

Während des Testens der Schaltungskomponente SK1 hat das Testkontrollsignal den Wert "0". Dies hat zur Folge, daß während des Testens der Schaltungskomponente SK1 das Signal, unter Verwendung dessen die Ausgangstreiber T gesteuert werden, dauerhaft den Wert "0" aufweist, wodurch die Ausgangstreiber T deaktiviert werden und keine Daten auf den Bus BUS ausgeben können.

Im Unterschied zur elektrischen Schaltung gemäß Figur 1 wird bei der elektrischen Schaltung gemäß Figur 2 das Testkontrollsignal TESTC nicht nur der zu testenden Schaltungskomponente SK1, sondern auch einer Bus-Terminierungslogik BTL, welche im betrachteten Beispiel Bestandteil der Bus-Steuereinrichtung BUSCONTROL ist, zugeführt.

Die Bus-Terminierungslogik BTL sorgt dafür, daß der Bus BUS während des Testens der Schaltungskomponente SK1 (wenn und so lange durch das Testkontrollsignal TESTC signalisiert wird, daß die Schaltungskomponente SK1 gerade getestet wird) durch eine der anderen Komponenten, die am Bus BUS angeschlossen sind, terminiert wird. Im betrachteten Beispiel terminiert die Bus-Terminierungslogik BTL den Bus BUS bei Bedarf selbst. Alternativ könnte vorgesehen werden, daß die Bus-Terminierungslogik BTL während des Testens der Schaltungskomponente SK1 die Ausgangstreiber einer der anderen an den Bus BUS angeschlossenen Schaltungskomponenten aktiviert und diese den Bus terminieren läßt.

Es dürfte einleuchten, daß die Logik, unter Verwendung welcher das Steuersignal zur Steuerung der Ausgangstreiber T generiert wird, nicht zwangsläufig ein wie beschrieben ausgebildetes und angeordnetes UND-Glied AND2 sein muß. Hierzu gibt es zahllose weitere Möglichkeiten: beispielsweise kann anstelle des UND-Gliedes AND2 ein NAND-Glied verwendet werden, oder ein Multiplexer, über welchen wahlweise das Freigabesignal EN oder das Testkontrollsignal TESTC zum Steueranschluß der Ausgangstreiber T durchgeschaltet wird.

Daß während des Testens der Schaltungskomponente SK1 keine Daten auf den Bus BUS ausgegeben werden, hat den positiven Effekt, daß die Ausgangstreiber T keinen oder nur einen vernachlässigbar geringen Energieverbrauch haben und sich demzufolge überhaupt nicht oder nur sehr wenig erhitzten.

Durch den geringen Energieverbrauch der elektrischen Schaltung während des Testens und die relativ niedrige Temperatur der elektrischen Schaltung während des Testens kann die zu testende Schaltungskomponente SK1 mit minimalem Aufwand zuverlässig getestet werden. Insbesondere ist es dadurch
- möglich, die Elemente (Nadeln), über welche die elektrische Schaltung während des Testens mit Energie versorgt wird, anzahl- und größenmäßig klein zu halten, und
- vergleichsweise einfach möglich, Tieftemperaturtests durchzuführen.

Diese Vorteile sind bei der elektrischen Schaltung gemäß Figur 2 noch ausgeprägter, als es bei der elektrischen Schaltung gemäß Figur 1 der Fall ist.

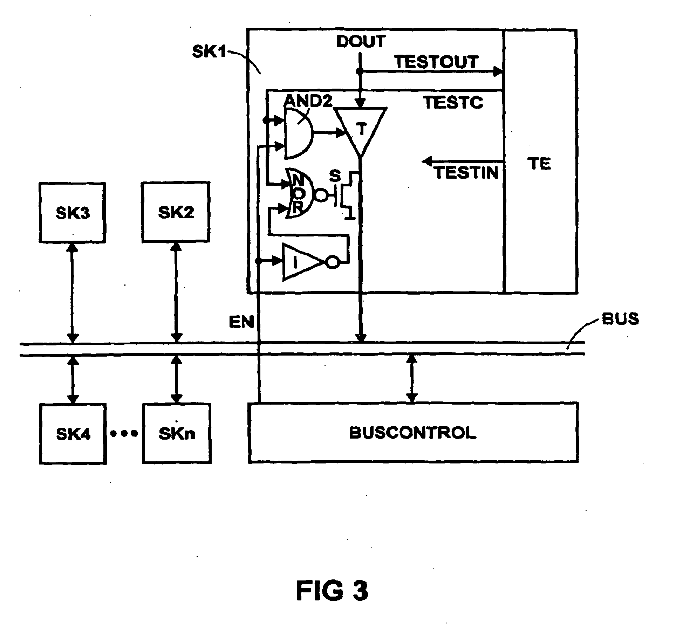

Durch die in Figur 3 gezeigte und nachfolgend unter Bezugnahme darauf beschriebene elektrische Schaltung lassen sich der Vorteil der elektrischen Schaltung gemäß Figur 1, nämlich daß während des Testens der zu testenden Schaltungskomponente die gegebenenfalls erforderliche Terminierung des Busses durch die zu testende Schaltungskomponente selbst erfolgt, und der Vorteil der elektrischen Schaltung gemäß Figur 2, nämlich daß die Ausgangstreiber der zu testenden Schaltungskomponente während des Testens derselben keinen oder nur einen vernachlässigbar geringen Energieverbrauch haben, vereinen.

Die in der Figur 3 gezeigte elektrische Schaltung entspricht großteils den in den Figuren 1 und 2 gezeigten elektrischen Schaltungen. Sie (die in der Figur 3 gezeigte elektrische Schaltung) besteht wie die in den Figuren 1 und 2 gezeigten elektrischen Schaltungen aus Schaltungskomponenten (Makros) SK1, SK2, ... SKn, einem die Schaltungskomponenten SK1, SK2, ... SKn verbindenden Bus BUS, und einer die Steuerung (insbesondere die Arbitrierung) des Busses BUS übernehmenden Bus-Steuereinrichtung BUSCONTROL. Von den vorhandenen Schaltungskomponenten SK1, SK2, ... SKn soll auch wieder die mit dem Bezugszeichen SK1 bezeichnete Schaltungskomponente einzeln, d. h. unabhängig von den anderen Schaltungskomponenten der elektrischen Schaltung getestet werden. Das Testen der zu testenden Schaltungskomponente erfolgt durch eine Testeinheit TE, die wie auch die in den elektrischen Schaltungen gemäß den Figuren 1 und 2 vorgesehene Testeinheit TE in der zu testenden Schaltungskomponente, d. h. der Schaltungskomponente SK1 enthalten ist. Insoweit besteht zwischen den elektrischen Schaltungen gemäß den Figuren 1 und 2 und der elektrischen Schaltung gemäß Figur 3 Übereinstimmung.

In Übereinstimmung mit der Schaltungskomponente SK1 gemäß Figur 1 und im Unterschied zur Schaltungskomponente SK1 gemäß Figur 2 gibt die Schaltungskomponente SK1 gemäß Figur 3 während des Testens derselben bei Bedarf (insbesondere wenn die Schaltungskomponente SK1 durch die Bus-Steuereinrichtung BUSCONTROL als Bus-Master bestimmt ist) Daten auf den Bus BUS aus.

Dies erfolgt im betrachteten Beispiel jedoch nicht über die auch bei der Schaltungskomponente SK1 gemäß Figur 3 vorhandenen Ausgangstreiber T, sondern durch die Beaufschlagung von zwischen den Ausgangsanschlüssen der Ausgangstreiber T und dem Bus BUS liegenden Stellen mit einem vorbestimmten Potential oder Potentialverlauf.

Das vorbestimmte Potential ist im betrachteten Beispiel das Massepotential. Es kann sich aber auch um ein beliebiges anderes Potential, und auch um ein sich zeitlich veränderndes Potential handeln.

Die Beaufschlagung der zwischen den Ausgangsanschlüssen der Ausgangstreiber T und dem Bus BUS liegenden Stellen mit einem vorbestimmten Potential oder Potentialverlauf erfolgt im betrachteten Beispiel über eine Schalteinrichtung S, welche vorliegend durch einen Transistor gebildet wird. Dabei spielt es grundsätzlich keine Rolle, um welche Art von Transistor es sich handelt. Anstelle des Transistors kann auch eine beliebige andere Schalteinrichtung verwendet werden, beispielsweise ein sogenanntes Transmission-Gate.

Die Schalteinrichtung S wird durch eine Logik gesteuert. Diese Logik besteht im betrachteten Beispiel aus einem NOR-Glied NOR und einem Inverter I, wobei das NOR-Glied NOR ein Testkontrollsignal TESTC und ein durch den Inverter I invertiertes Freigabesignal EN als Eingangssignale erhält, und wobei das Ausgangssignal des NOR-Gliedes NOR zur Steuerung der Schalteinrichtung S verwendet wird.

Das Testkontrollsignal TESTC und das Freigabesignal EN entsprechen den gleichnamigen Signalen bei den elektrischen Schaltungen gemäß den Figuren 1 und 2.

Die Ausgangstreiber T der zu testenden Schaltungskomponente SK1 sind während des Testens derselben deaktiviert. Dies wird im betrachteten Beispiel dadurch erreicht, daß die (Steuer)Anschlüsse der Ausgangstreiber T, über welche diese aktivierbar und deaktivierbar sind, wie bei der elektrischen Schaltung gemäß Figur 2 mit dem Ausgangssignal einer dem Steueranschluß vorgeschalteten Logik beaufschlagt werden.

Diese Logik besteht im betrachteten Beispiel wie bei der elektrischen Schaltung gemäß Figur 2 aus einem AND-Glied AND2, welches das Testkontrollsignal TESTC und das Freigabesignal EN als Eingangssignale erhält, und dessen Ausgangssignal zur Steuerung der Ausgangstreiber T verwendet wird.

Die die Terminierung des Busses BUS steuernde Schalteinrichtung S und die Ausgangstreiber T werden durch die Logiken AND2 und I/NOR so gesteuert, daß sich im Ergebnis folgende Verhältnisse einstellen:

| TESTC | EN | Wirkung |
|---|---|---|
| 0 | 0 | Testbetrieb Ausgangstreiber deaktiviert Terminierung inaktiv |
| 0 | 1 | Testbetrieb Ausgangstreiber deaktiviert Terminierung aktiv |
| 1 | 0 | Normalbetrieb Ausgangstreiber deaktiviert |
| 1 | 1 | Normalbetrieb Ausgangstreiber aktiviert |

Die elektrische Schaltung gemäß Figur 3
- weist gegenüber der elektrischen Schaltung gemäß Figur 1 die Vorteile auf,
   - daß sich in dem Pfad, über welchen im Normalbetrieb die Daten DOUT ausgegeben werden, keine zusätzliche Logik befindet, wodurch die Datenausgabe schneller erfolgen kann, und
   - daß die Ausgangstreiber während des Testens der zu testenden Schaltungskomponente deaktiviert sind, wodurch sie während des Testens weniger Energie verbrauchen und sich demzufolge auch weniger erhitzen, und
- weist gegenüber der elektrischen Schaltung gemäß Figur 2 den Vorteil auf, das die zu testende Schaltungskomponente den Bus selbst terminiert, wodurch auf die Bus-Terminierungslogik BTL oder ähnliche Einrichtungen verzichtet werden kann.
und dies ohne Inkaufnahme nennenswerter Nachteile gegenüber den elektrischen Schaltungen gemäß den Figuren 1 und 2.

Es dürfte einleuchten, daß die Logiken, unter Verwendung welcher die Steuersignale zur Steuerung der Ausgangstreiber T und der Schalteinrichtung S generiert werden, nicht zwangsläufig wie beschrieben ausgebildet und angeordnet müssen. Hierzu gibt es zahllose weitere Möglichkeiten.

Daß die Ausgangstreiber T während des Testens der Schaltungskomponente SK1 deaktiviert sind, hat den positiven Effekt, daß sie keinen oder nur einen vernachlässigbar geringen Energieverbrauch haben und sich demzufolge überhaupt nicht oder nur sehr wenig erhitzten.

Durch den geringen Energieverbrauch der elektrischen Schaltung während des Testens und die relativ niedrige Temperatur der elektrischen Schaltung während des Testens kann die zu testende Schaltungskomponente SK1 mit minimalem Aufwand zuverlässig getestet werden. Insbesondere ist es dadurch
- möglich, die Elemente (Nadeln), über welche die elektrische Schaltung während des Testens mit Energie versorgt wird, anzahl- und größenmäßig klein zu halten, und
- vergleichsweise einfach möglich, Tieftemperaturtests durchzuführen.

Die zum Testen der zu testenden Schaltungskomponente getroffenen Vorkehrungen beeinträchtigen diese im Normalbetrieb in keinster Weise. Insbesondere sind keinerlei Auswirkungen auf die Arbeitsgeschwindigkeit und die weiteren wesentlichen Eigenschaften der zu testenden Schaltungskomponente zu befürchten.

Den beschriebenen elektrischen Schaltungen ist unabhängig von den Einzelheiten der praktischen Realisierung gemeinsam, daß sie es auf verblüffend einfache Weise ermöglichen, zu testende Schaltungskomponenten mit minimalem Aufwand zuverlässig zu testen.

## Patentansprüche

1. Elektrische Schaltung mit über einen Bus (BUS) verbundenen Schaltungskomponenten (SK1-SKn), wobei wenigstens eine der Schaltungskomponenten (SK1) unabhängig von den anderen Schaltungskomponenten (SK2-SKn) testbar ist,
**dadurch gekennzeichnet,**
**daß** die wenigstens eine Schaltungskomponente (SK1), die unabhängig von den anderen Schaltungskomponenten (SK2-SKn) testbar ist, während des Testens der wenigstens einen Schaltungskomponente (SK1), keine Daten auf den Bus (BUS) ausgibt oder anstelle der Daten (DOUT), die im normalen Betrieb auf den Bus auszugeben wären, andere Daten auf den Bus ausgibt, wobei die anderen Daten so gewählt sind, daß der Energieverbrauch der Ausgangstreiber (T) der wenigstens einen Schaltungskomponente (SK1) minimal ist.

2. Elektrische Schaltung nach Anspruch 1,
**dadurch gekennzeichnet,**
**daß** die Ausgangstreiber (T), über welche die wenigstens eine Schaltungskomponente (SK1), die unabhängig von den anderen Schaltungskomponenten (SK2-SKn) testbar ist, auf den Bus (BUS) auszugebende Daten auf den Bus ausgibt, während des Testens der Schaltungskomponente deaktiviert werden.

3. Elektrische Schaltung nach Anspruch 2,
**dadurch gekennzeichnet,**
**daß** die Deaktivierung der Ausgangstreiber (T) durch eine die wenigstens eine Schaltungskomponente (SK1), die unabhängig von den anderen Schaltungskomponenten (SK2-SKn) testbar ist, testende Testeinheit (TE) veranlaßt wird.

4. Elektrische Schaltung nach Anspruch 2 oder 3,
**dadurch gekennzeichnet,**
**daß** die Deaktivierung der Ausgangstreiber (T) unter Verwendung einer ersten Logik (AND2) oder einer ersten Auswahlschaltung erfolgt, durch welche dafür gesorgt wird, daß die Ausgangstreiber während des normalen Betriebes der wenigstens einen Schaltungskomponente (SK1), die unabhängig von den anderen Schaltungskomponenten (SK2-SKn) testbar ist, abhängig von einem Freigabesignal (EN) gesteuert werden, welches den Schaltungskomponenten von einer den Bus (BUS) steuernden Bus-Steuereinrichtung (BUSCONTROL) zugeführt wird, und durch welche dafür gesorgt wird, daß die Ausgangstreiber (T) während des Testens der wenigstens einen Schaltungskomponente (SK1), die unabhängig von den anderen Schaltungskomponenten (SK2-SKn) testbar ist, abhängig von einem Testkontrollsignal (TESTC) gesteuert werden, welches der wenigstens einen Schaltungskomponente (SK1), die unabhängig von den anderen Schaltungskomponenten (SK2-SKn) testbar ist, von der den Test durchführenden Testeinheit (TE) zugeführt wird.

5. Elektrische Schaltung nach Anspruch 4,
**dadurch gekennzeichnet,**
**daß** das Ausgangssignal der ersten Logik (AND2) das Ergebnis einer logischen Verknüpfung des Freigabesignals (EN) und des Testkontrollsignals (TESTC) ist.

6. Elektrische Schaltung nach Anspruch 4,
**dadurch gekennzeichnet,**
**daß** die erste Auswahlschaltung durch einen Multiplexer gebildet wird, welcher wahlweise das Freigabesignal (EN) oder das Testkontrollsignal (TESTC) zu den Steueranschlüssen der Ausgangstreiber (T) durchschaltet.

7. Elektrische Schaltung nach einem der vorhergehenden Ansprüche,
**dadurch gekennzeichnet,**
**daß** das Testen der wenigstens einen Schaltungskomponente (SK1), die unabhängig von den anderen Schaltungskomponenten (SK2-SKn) testbar ist, einer den Bus (BUS) steuernden Bus-Steuereinrichtung (BUSCONTROL) signalisiert wird.

8. Elektrische Schaltung nach Anspruch 7,
**dadurch gekennzeichnet,**
**daß** die Bus-Steuereinrichtung (BUSCONTROL) während des Testens der wenigstens einen Schaltungskomponente (SK1), die unabhängig von den anderen Schaltungskomponenten (SK2-SKn) testbar ist, dafür sorgt, das der Bus durch eine der anderen Schaltungskomponenten (SK2-SKn) oder durch die Bus-Steuereinrichtung (BUSCONTROL) selbst terminiert wird.

9. Elektrische Schaltung nach Anspruch 1,
**dadurch gekennzeichnet,**
**daß** die Daten, die die wenigstens eine Schaltungskomponente (SK1), die unabhängig von den anderen Schaltungskomponenten (SK2-SKn) testbar ist, während des Testens derselben auf den Bus (BUS) ausgibt, sich nicht oder nur selten verändern.

10. Elektrische Schaltung nach Anspruch 9,
**dadurch gekennzeichnet,**
**daß** die Auswahl der auf den Bus (BUS) auszugebenden Daten unter Verwendung einer zweiten Logik (AND) oder einer zweiten Auswahlschaltung erfolgt, durch welche dafür gesorgt wird, daß während des normalen Betriebes der wenigstens einen Schaltungskomponente (SK1), die unabhängig von den anderen Schaltungskomponenten (SK2-SKn) testbar ist, die eigentlich auf den Bus auszugebenden Daten (DOUT) auf den Bus ausgegeben werden, und durch welche dafür gesorgt wird, daß während des Testens der wenigstens einen Schaltungskomponente (SK1), die unabhängig von den anderen Schaltungskomponenten (SK2-SKn) testbar ist, Daten auf den Bus (BUS) ausgegeben werden, welche der wenigstens einen Schaltungskomponente (SK1), die unabhängig von den anderen Schaltungskomponenten (SK2-SKn) testbar ist, von einer den Test durchführenden Testeinheit (TE) zugeführt werden.

11. Elektrische Schaltung nach Anspruch 10,
**dadurch gekennzeichnet,**
**daß** das Ausgangssignal der zweiten Logik (AND) das Ergebnis einer logischen Verknüpfung der im Normalfall auf den Bus auszugebenden Daten (DOUT) und eines Testkontrollsignals (TESTC) ist, durch welches die Testeinheit (TE) signalisiert, daß sie die wenigstens eine Schaltungskomponente (SK1), die unabhängig von den anderen Schaltungskomponenten (SK2-SKn) testbar ist, gerade testet.

12. Elektrische Schaltung nach Anspruch 10,
**dadurch gekennzeichnet,**
**daß** die zweite Auswahlschaltung durch einen Multiplexer gebildet wird, welcher wahlweise die im Normalfall auf den Bus (BUS) auszugebenden Daten (DOUT) oder ein der wenigstens einen Schaltungskomponente (SK1), die unabhängig von den anderen Schaltungskomponenten (SK2-SKn) testbar ist, von der Testeinheit (TE) zugeführtes Testkontrollsignal (TESTC) zu den Eingangsanschlüssen der Ausgangstreiber (T) der wenigstens einen Schaltungskomponente (SK1), die unabhängig von den anderen Schaltungskomponenten (SK2-SKn) testbar ist, über welche die wenigstens eine Schaltungskomponente (SK1), die unabhängig von den anderen Schaltungskomponenten (SK2-SKn) testbar ist auf den Bus auszugebende Daten auf den Bus ausgibt, durchschaltet.

13. Elektrische Schaltung nach einem der Ansprüche 10 bis 12,
**dadurch gekennzeichnet,**
**daß** die wenigstens eine Schaltungskomponente (SK1), die unabhängig von den anderen Schaltungskomponenten (SK2-SKn) testbar ist, Ausgangstreiber (T) enthält, über welche die wenigstens eine Schaltungskomponente (SK1), die unabhängig von den anderen Schaltungskomponenten (SK2-SKn) testbar ist, auf den Bus (BUS) auszugebende Daten auf den Bus ausgibt, und daß für jeden Ausgangstreiber (T) eine eigene zweite Logik (AND) oder zweite Auswahlschaltung vorgesehen ist.

14. Elektrische Schaltung nach Anspruch 13,
**dadurch gekennzeichnet,**
**daß** das Ausgangssignal der zweiten Logik (AND) oder zweiten Auswahlschaltung das Eingangssignal des zugeordneten Ausgangstreibers (T) ist.

15. Elektrische Schaltung nach einem der Ansprüche 1 bis 6 und 9,
**dadurch gekennzeichnet,**
**daß** die während des Testens der wenigstens einen Schaltungskomponente (SK1), die unabhängig von den anderen Schaltungskomponenten (SK2-SKn) testbar ist, durch die zu testende Schaltungskomponente auf den Bus ausgegebenen Daten an zwischen den Ausgangsanschlüssen der Ausgangstreiber (T) und dem Bus (BUS) liegenden Stellen eingespeist werden.

16. Elektrische Schaltung nach Anspruch 15,
**dadurch gekennzeichnet,**
**daß** die Einspeisung über eine Schalteinrichtung (S) erfolgt.

17. Elektrische Schaltung nach Anspruch 16,
**dadurch gekennzeichnet,**
**daß** die Schalteinrichtung (S) durch eine dritte Logik (I, NOR) gesteuert wird.

18. Elektrische Schaltung nach Anspruch 17,
**dadurch gekennzeichnet,**
**daß** das Ausgangssignal der dritten Logik (I, NOR) das Ergebnis einer logischen Verknüpfung des Freigabesignals (EN) und des Testkontrollsignals (TESTC) ist.

19. Elektrische Schaltung nach einem der Ansprüche 16 bis 18,
**dadurch gekennzeichnet,**
**daß** die Schalteinrichtung (S) im durchgeschalteten Zustand die Stelle, an welcher die während des Testens auf den Bus (BUS) auszugebenden Daten eingespeist werden, mit einem ein vorbestimmtes Potential aufweisenden Punkt verbindet.

20. Verfahren zum Testen einer Schaltungskomponente (SK1), die über einen Bus (BUS) mit anderen Schaltungskomponenten (SK2-SKn) verbunden ist, wobei die zu testende Schaltungskomponente unabhängig von den anderen Schaltungskomponenten testbar ist,
**dadurch gekennzeichnet,**
**daß** dafür gesorgt wird, daß die zu testende Schaltungskomponente (SK1) während des Testens der zu testenden Schaltungskomponente (SK1) keine Daten auf den Bus (BUS) ausgibt oder daß sie anstelle der Daten (DOUT), die im normalen Betrieb auf den Bus auszugeben wären, andere Daten auf den Bus ausgibt, wobei die anderen Daten so gewählt werden, daß der Energieverbrauch der Ausgangstreiber (T) der zu testenden Schaltungskomponente (SK1) minimal ist.

21. Verfahren nach Anspruch 20,
**dadurch gekennzeichnet,**
**daß** die Ausgangstreiber (T), über welche die zu testende Schaltungskomponente (SK1) auf den Bus (BUS) auszugebende Daten auf den Bus ausgibt, während des Testens der Schaltungskomponente deaktiviert werden.

22. Verfahren nach Anspruch 21,
**dadurch gekennzeichnet,**
**daß** die Deaktivierung der Ausgangstreiber (T) durch eine die zu testende Schaltungskomponente (SK1) testende Testeinheit (TE) veranlaßt wird.

23. Verfahren nach Anspruch 21 oder 22,
**dadurch gekennzeichnet,**
**daß** die Deaktivierung der Ausgangstreiber (T) unter Verwendung einer ersten Logik (AND2) oder einer ersten Auswahlschaltung erfolgt, durch welche dafür gesorgt wird, daß die Ausgangstreiber während des normalen Betriebes der zu testenden Schaltungskomponente (SK1) abhängig von einem Freigabesignal (EN) gesteuert werden, welches den Schaltungskomponenten von einer den Bus (BUS) steuernden Bus-Steuereinrichtung (BUSCONTROL) zugeführt wird, und durch welche dafür gesorgt wird, daß die Ausgangstreiber (T) während des Testens der zu testenden Schaltungskomponente (SK1) abhängig von einem Testkontrollsignal (TESTC) gesteuert werden, welches der zu testenden Schaltungskomponente von der den Test durchführenden Testeinheit (TE) zugeführt wird.

24. Verfahren nach Anspruch 23,
**dadurch gekennzeichnet,**
**daß** das Ausgangssignal der ersten Logik (AND2) das Ergebnis einer logischen Verknüpfung des Freigabesignals (EN) und des Testkontrollsignals (TESTC) ist.

25. Verfahren nach Anspruch 23,
**dadurch gekennzeichnet,**
**daß** die erste Auswahlschaltung durch einen Multiplexer gebildet wird, welcher wahlweise das Freigabesignal (EN) oder das Testkontrollsignal (TESTC) zu den Steueranschlüssen der Ausgangstreiber (T) durchschaltet.

26. Verfahren nach einem der vorhergehenden Ansprüche,
**dadurch gekennzeichnet,**
**daß** das Testen der zu testenden Schaltungskomponente (SK1) einer den Bus (BUS) steuernden Bus-Steuereinrichtung (BUSCONTROL) signalisiert wird.

27. Verfahren nach Anspruch 26,
**dadurch gekennzeichnet,**
**daß** die Bus-Steuereinrichtung (BUSCONTROL) während des Testens der zu testenden Schaltungskomponente (SK1) dafür sorgt, das der Bus durch eine der anderen Schaltungskomponenten (SK2-SKn) oder durch die Bus-Steuereinrichtung (BUSCONTROL) selbst terminiert wird.

28. Verfahren nach Anspruch 20,
**dadurch gekennzeichnet,**
**daß** die Daten, die die zu testenden Schaltungskomponente (SK1) während des Testens derselben auf den Bus (BUS) ausgibt, sich nicht oder nur selten verändern.

29. Verfahren nach Anspruch 28,
**dadurch gekennzeichnet,**
**daß** die Auswahl der auf den Bus (BUS) auszugebenden Daten unter Verwendung einer zweiten Logik (AND) oder einer zweiten Auswahlschaltung erfolgt, durch welche dafür gesorgt wird, daß während des normalen Betriebes der zu testenden Schaltungskomponente (SK1) die eigentlich auf den Bus auszugebenden Daten (DOUT) auf den Bus ausgegeben werden, und durch welche dafür gesorgt wird, daß während des Testens der zu testenden Schaltungskomponente (SK1) Daten auf den Bus (BUS) ausgegeben werden, welche der zu testenden Schaltungskomponente von einer den Test durchführenden Testeinheit (TE) zugeführt werden.

30. Verfahren nach Anspruch 29,
**dadurch gekennzeichnet,**
**daß** das Ausgangssignal der zweiten Logik (AND) das Ergebnis einer logischen Verknüpfung der im Normalfall auf den Bus auszugebenden Daten (DOUT) und eines Testkontrollsignals (TESTC) ist, durch welches die Testeinheit (TE) signalisiert, daß sie die zu testenden Schaltungskomponente (SK1) gerade testet.

31. Verfahren nach Anspruch 29,
**dadurch gekennzeichnet,**
**daß** die zweite Auswahlschaltung durch einen Multiplexer gebildet wird, welcher wahlweise die im Normalfall auf den Bus (BUS) auszugebenden Daten (DOUT) oder ein der zu testenden Schaltungskomponente (SK1) von der Testeinheit (TE) zugeführtes Testkontrollsignal (TESTC) zu den Eingangsanschlüssen der Ausgangstreiber (T) der zu testenden Schaltungskomponente, über welche die zu testende Schaltungskomponente auf den Bus auszugebende Daten auf den Bus ausgibt, durchschaltet.

32. Verfahren nach einem der Ansprüche 29 bis 31,
**dadurch gekennzeichnet,**
**daß** die zu testenden Schaltungskomponente (SK1) Ausgangstreiber (T) enthält, über welche die zu testende Schaltungskomponente (SK1) auf den Bus (BUS) auszugebende Daten auf den Bus ausgibt, und
**daß** für jeden Ausgangstreiber (T) eine eigene zweite Logik (AND) oder zweite Auswahlschaltung vorgesehen ist.

33. Verfahren nach Anspruch 32,
**dadurch gekennzeichnet,**
**daß** das Ausgangssignal der zweiten Logik (AND) oder zweiten Auswahlschaltung das Eingangssignal des zugeordneten Ausgangstreibers (T) ist.

34. Verfahren nach einem der Ansprüche 20 bis 25 und 28,
**dadurch gekennzeichnet,**
**daß** die während des Testens der zu testenden Schaltungskomponente (SK1) durch die zu testende Schaltungskomponente auf den Bus ausgegebenen Daten an zwischen den Ausgangsanschlüssen der Ausgangstreiber (T) und dem Bus (BUS) liegenden Stellen eingespeist werden.

35. Verfahren nach Anspruch 34,
**dadurch gekennzeichnet,**
**daß** die Einspeisung über eine Schalteinrichtung (S) erfolgt.

36. Verfahren nach Anspruch 35,
**dadurch gekennzeichnet,**
**daß** die Schalteinrichtung (S) durch eine dritte Logik (I, NOR) gesteuert wird.

37. Verfahren nach Anspruch 36,
**dadurch gekennzeichnet,**
**daß** das Ausgangssignal der dritten Logik (I, NOR) das Ergebnis einer logischen Verknüpfung des Freigabesignals (EN) und des Testkontrollsignals (TESTC) ist.

38. Verfahren nach einem der Ansprüche 35 bis 37,
**dadurch gekennzeichnet,**
**daß** die Schalteinrichtung (S) im durchgeschalteten Zustand die Stelle, an welcher die während des Testens auf den Bus (BUS) auszugebenden Daten eingespeist werden, mit einem ein vorbestimmtes Potential aufweisenden Punkt verbindet.

## Claims

1. Electrical circuit having circuit components (SK1-SKn) connected via a bus (BUS), where at least one of the circuit components (SK1) can be tested independently of the other circuit components (SK2-Skn),
**characterized**
**in that** the at least one circuit component (SK1) which can be tested independently of the other circuit components (SK2-SKn) does not output any data to the bus (BUS) while the at least one circuit component (SK1) is being tested, or outputs other data to the bus instead of the data (DOUT) which would need to be output to the bus during normal operation, the other data having been chosen such that the power consumption of the output drivers (T) in the at least one circuit component (SK1) is minimal.

2. Electrical circuit according to Claim 1,
**characterized**
**in that** the output drivers (T) which the at least one circuit component (SK1) which can be tested independently of the other circuit components (SK2-SKn) uses to output data, needing to be output to the bus (BUS), to the bus are deactivated while the circuit component is being tested.

3. Electrical circuit according to Claim 2,
**characterized**
**in that** the deactivation of the output drivers (T) is prompted by a test unit (TE) which tests the at least one circuit component (SK1) which can be tested independently of the other circuit components (SK2-SKn).

4. Electrical circuit according to Claim 2 or 3,
**characterized**
**in that** the output drivers (T) are deactivated using a first logic unit (AND2) or a first selection circuit which ensures that during normal operation of the at least one circuit component (SK1) which can be tested independently of the other circuit components (SK2-SKn) the output drivers are controlled on the basis of an enable signal (EN) which is supplied to the circuit components by a bus control device (BUSCONTROL) which controls the bus (BUS), and which ensures that during testing of the at least one circuit component (SK1) which can be tested independently of the other circuit components (SK2-SKn) the output drivers (T) are controlled on the basis of a test control signal (TESTC) which is supplied to the at least one circuit component (SK1) which can be tested independently of the other circuit components (SK2-SKn) by the test unit (TE) which performs the test.

5. Electrical circuit according to Claim 4, **characterized**
**in that** the output signal from the first logic unit (AND2) is the result of logic combination of the enable signal (EN) and the test control signal (TESTC).

6. Electrical circuit according to Claim 4,
**characterized**
**in that** the first selection circuit is formed by a multiplexer which selectively connects the enable signal (EN) or the test control signal (TESTC) to the control connections of the output drivers (T).

7. Electrical circuit according to one of the preceding claims,
**characterized**
**in that** the testing of the at least one circuit component (SK1) which can be tested independently of the other circuit components (SK2-SKn) is signalled to a bus control device (BUSCONTROL) which controls the bus (BUS).

8. Electrical circuit according to Claim 7,
**characterized**
**in that** during testing of the at least one circuit component (SK1) which can be tested independently of the other circuit components (SK2-SKn) the bus control device (BUSCONTROL) ensures that the bus is terminated by one of the other circuit components (SK2-SKn) or by the bus control device (BUSCONTROL) itself.

9. Electrical circuit according to Claim 1,
**characterized**
**in that** the data which the at least one circuit component (SK1) which can be tested independently of the other circuit components (SK2-SKn) outputs to the bus (BUS) while said circuit component is being tested do not change or change only infrequently.

10. Electrical circuit according to Claim 9,
**characterized**
**in that** the data to be output to the bus (BUS) are selected using a second logic unit (AND) or a second selection circuit which ensures that during normal operation of the at least one circuit component (SK1) which can be tested independently of the other circuit components (SK2-SKn) the data (DOUT) which are actually to be output to the bus are output to the bus, and which ensures that during testing of the at least one circuit component (SK1) which can be tested independently of the other circuit components (SK2-SKn) data are output to the bus (BUS) which are supplied to the at least one circuit component (SK1) which can be tested independently of the other circuit components (SK2-SKn) by a test unit (TE) which performs the test.

11. Electrical circuit according to Claim 10,
**characterized**
**in that** the output signal from the second logic unit (AND) signals the result of logic combination of the data (DOUT) to be output to the bus normally and a test control signal (TESTC) which the test unit (TE) uses to signal that it is currently testing the at least one circuit component (SK1) which can be tested independently of the other circuit components (SK2-SKn).

12. Electrical circuit according to Claim 10,
**characterized**
**in that** the second selection circuit is formed by a multiplexer which selectively connects the data (DOUT) to be output to the bus (BUS) normally, or a test control signal (TESTC) supplied to the at least one circuit component (SK1) which can be tested independently of the other circuit components (SK2-SKn) by the test unit (TE), to the input connections of the output drivers (T) in the at least one circuit component (SK1) which can be tested independently of the other circuit components (SK2-SKn), which the at least one circuit component (SK1) which can be tested independently of the other circuit components (SK2-SKn) uses to output data, needing to be output to the bus, to the bus.

13. Electrical circuit according to one of Claims 10 to 12,
**characterized**
**in that** the at least one circuit component (SK1) which can be tested independently of the other circuit components (SK2-SKn) contains output drivers (T) which the at least one circuit component (SK1) which can be tested independently of the other circuit components (SK2-SKn) uses to output data, needing to be output to the bus (BUS), to the bus, and in that each output driver (T) has a dedicated second logic unit (AND) or second selection circuit provided for it.

14. Electrical circuit according to Claim 13,
**characterized**
**in that** the output signal from the second logic unit (AND) or second selection circuit is the input signal for the associated output driver (T).

15. Electrical circuit according to one of Claims 1 to 6 and 9,
**characterized**
**in that** the data output to the bus by the circuit component to be tested while the at least one circuit component (SK1) which can be tested independently of the other circuit components (SK2-SKn) is being tested are furnished at locations situated between the output connections of the output drivers (T) and the bus (BUS).

16. Electrical circuit according to Claim 15,
**characterized**
**in that** said furnishing takes place via a switching device (S) .

17. Electrical circuit according to Claim 16,
**characterized**
**in that** the switching device (S) is controlled by a third logic unit (I, NOR).

18. Electrical circuit according to Claim 17,
**characterized**
**in that** the output signal from the third logic unit (I, NOR) is the result of logic combination of the enable signal (EN) and the test control signal (TESTC).

19. Electrical circuit according to one of Claims 16 to 18,
**characterized**
**in that**, when turned on, the switching device (S) connects the location at which the data to be output to the bus (BUS) during testing are furnished to a point which is at a predetermined potential.

20. Method for testing a circuit component (SK1) which is connected to other circuit components (SK2-SKn) via a bus (BUS), the circuit component to be tested being able to be tested independently of the other circuit components,
**characterized**
**in that** it is ensured that the circuit component (SK1) to be tested does not output any data to the bus (BUS) while the circuit component (SK1) to be tested is being tested, or that it outputs other data to the bus instead of the data (DOUT) which would need to be output to the bus during normal operation, the other data being chosen such that the power consumption of the output drivers (T) in the circuit component (SK1) to be tested is minimal.

21. Method according to Claim 20,
**characterized**
**in that** the output drivers (T) which the circuit component (SK1) to be tested uses to output data, needing to be output to the bus (BUS), to the bus are deactivated while the circuit component is being tested.

22. Method according to Claim 21,
**characterized**
**in that** the deactivation of the output drivers (T) is prompted by a test unit (TE) which tests the circuit component (SK1) to be tested.

23. Method according to Claim 21 or 22,
**characterized**
**in that** the output drivers (T) are deactivated using a first logic unit (AND2) or a first selection circuit which ensures that during normal operation of the circuit component (SK1) which is to be tested the output drivers are controlled on the basis of an enable signal (EN) which is supplied to the circuit components by a bus control device (BUSCONTROL) which controls the bus (BUS), and which ensures that during testing of the circuit component (SK1) to be tested the output drivers (T) are controlled on the basis of a test control signal (TESTC) which is supplied to the circuit component to be tested by the test unit (TE) which performs the test.

24. Method according to Claim 23,
**characterized**
**in that** the output signal from the first logic unit (AND2) is the result of logic combination of the enable signal (EN) and the test control signal (TESTC).

25. Method according to Claim 23,
**characterized**
**in that** the first selection circuit is formed by a multiplexer which selectively connects the enable signal (EN) or the test control signal (TESTC) to the control connections of the output drivers (T).

26. Method according to one of the preceding claims,
**characterized**
**in that** the testing of the circuit component (SK1) to be tested is signalled to a bus control device (BUSCONTROL) which controls the bus (BUS).

27. Method according to Claim 26,
**characterized**
**in that** during testing of the circuit component (SK1) to be tested the bus control device (BUSCONTROL) ensures that the bus is terminated by one of the other circuit components (SK2-SKn) or by the bus control device (BUSCONTROL) itself.

28. Method according to Claim 20,
**characterized**
**in that** the data which the circuit component (SK1) to be tested outputs to the bus (BUS) while said circuit component is being tested do not change or change only infrequently.

29. Method according to Claim 28,
**characterized**
**in that** the data to be output to the bus (BUS) are selected using a second logic unit (AND) or a second selection circuit which ensures that during normal operation of the circuit component (SK1) to be tested the data (DOUT) which are actually to be output to the bus are output to the bus, and which ensures that during testing of the circuit component (SK1) which is to be tested data are output to the bus (BUS) which are supplied to the circuit component to be tested by a test unit (TE) which performs the test.

30. Method according to Claim 29,
**characterized**
**in that** the output signal from the second logic unit (AND) is the result of logic combination of the data (DOUT) to be output to the bus normally and a test control signal (TESTC) which the test unit (TE) uses to signal that it is currently testing the circuit component (SK1) which is to be tested.

31. Method according to Claim 29,
**characterized**
**in that** the second selection circuit is formed by a multiplexer which selectively connects the data (DOUT) which are to be output to the bus (BUS) normally, or a test control signal (TESTC) supplied to the circuit component (SK1) to be tested by the test unit (TE), to the input connections of the output drivers (T) in the circuit component to be tested, which the circuit component to be tested uses to output data, needing to be output to the bus, to the bus.

32. Method according to one of Claims 29 to 31,
**characterized**
**in that** the circuit component (SK1) to be tested contains output drivers (T) which the circuit component (SK1) to be tested uses to output data, needing to be output to the bus (BUS), to the bus, and
**in that** each output driver (T) has a dedicated second logic unit (AND) or second selection circuit provided for it.

33. Method according to Claim 32,
**characterized**
**in that** the output signal from the second logic unit (AND) or second selection circuit is the input signal for the associated output driver (T).

34. Method according to one of Claims 20 to 25 and 28,
**characterized**
**in that** the data which are output to the bus by the circuit component to be tested while the circuit component (SK1) to be tested is being tested are furnished at locations situated between the output connections of the output drivers (T) and the bus (BUS).

35. Method according to Claim 34,
**characterized**
**in that** said furnishing takes place via a switching device (S).

36. Method according to Claim 35,
**characterized**
**in that** the switching device (S) is controlled by a third logic unit (I, NOR).

37. Method according to Claim 36,
**characterized**
**in that** the output signal from the third logic unit (I, NOR) is the result of logic combination of the enable signal (EN) and the test control signal (TESTC).

38. Method according to one of Claims 35 to 37,
**characterized**
**in that**, when turned on, the switching device (S) connects the location at which the data to be output to the bus (BUS) during testing are furnished to a point which is at a predetermined potential.

## Revendications

1. Circuit électrique qui présente des composants de circuit (SK1-SKn) reliés par un bus (BUS) et dans lequel au moins un des composants de circuit (SK1) peut être testé indépendamment des autres composants de circuit (SK2-Skn),
**caractérisé en ce que**
le ou les composants de circuit (SK1) qui peuvent être testés indépendamment des autres composants de circuit (SK2-SKn) ne délivrent pas de données sur le bus (BUS) pendant le test du ou des composants de circuit (SK1) ou délivrent sur le bus d'autres données que les données (DOUT) qui devraient être délivrées en fonctionnement normal sur le bus, les autres données étant sélectionnées de manière à minimiser la consommation en énergie des pilotes de sortie (T) du ou des composés (SK1).

2. Circuit électrique selon la revendication 1, **caractérisé en ce que** les pilotes de sortie (T) du ou des composants de circuit (SK1) qui peuvent être testés indépendamment des autres composants de circuit (SK2-SKn) et par lesquels le ou les composants de circuit (SK1) qui peuvent être testés indépendamment des autres composants de circuit (SK2-SKn) délivrent sur le bus les données à délivrer sur le bus (BUS) sont désactivés pendant que le composant de circuit est testé.

3. Circuit électrique selon la revendication 2, **caractérisé en ce que** la désactivation des pilotes de sortie (T) est lancée par une unité de test (TE) qui teste le ou les composants de circuit (SK1) qui peuvent être testés indépendamment des autres composants de circuit (SK2-SKn).

4. Circuit électrique selon les revendications 2 ou 3, **caractérisé en ce que** la désactivation des pilotes de sortie (T) s'effectue en utilisant une première logique (AND2) ou un premier circuit de sélection qui assurent, pendant le fonctionnement normal du ou des composants de circuit (SK1) qui peuvent être testés indépendamment des autres composants de circuit (SK2-SKn), que les pilotes de sortie sont commandés en fonction d'un signal de libération (EN) qui est amené aux composants de circuit par un dispositif (BUSCONTROL) de contrôle de bus qui contrôle le bus (BUS) et qui assurent que pendant le test du ou des composants de circuit (SK1) qui peuvent être testés indépendamment des autres composants de circuit (SK2-SKn), les pilotes de sortie (T) sont commandés en fonction d'un signal de contrôle de test (TESTC) qui est appliqué sur le ou les composants de circuit (SK1) qui peuvent être testés indépendamment des autres composants de circuit (SK2-SKn) par l'unité de test (TE) qui exécute le test.

5. Circuit électrique selon la revendication 4, **caractérisé en ce que** le signal de sortie de la première logique (AND2) est le résultat d'une association logique du signal de libération (EN) et du signal de contrôle de test (TESTC).

6. Circuit électrique selon la revendication 4, **caractérisé en ce que caractérisé en ce que** le signal de sortie de la première logique (AND2) est le résultat d'une association logique du signal de libération (EN) et du signal de contrôle de test (TESTC).

7. Circuit électrique selon l'une des revendications précédentes, **caractérisé en ce que** le test du ou des composants de circuit (SK1) qui peuvent être testés indépendamment des autres composants de circuit (SK2-SKn) est signalé à un dispositif (BUSCONTROL) de commande de bus qui commande le bus (BUS).

8. Circuit électrique selon la revendication 7, **caractérisé en ce que** pendant le test du ou des composants de circuit (SK1) qui peuvent être testés indépendamment des autres composants de circuit (SK2-SKn), le dispositif (BUSCONTROL) de commande de bus assure que le bus est interrompu par un des autres composants de circuit (SK2-SKn) ou par le dispositif (BUSCONTROL) de commande de bus proprement dit.

9. Circuit électrique selon la revendication 1, **caractérisé en ce que** les données que le ou les composants de circuit (SK1) qui peuvent être testés indépendamment des autres composants de circuit (SK2-SKn) délivrent sur le bus (BUS) pendant qu'ils sont testés ne se modifient pas ou ne se modifient que rarement.

10. Circuit électrique selon la revendication 9, **caractérisé en ce que** la sélection des données à délivrer sur le bus (BUS) s'effectue en recourant à une deuxième logique (AND) ou à un deuxième circuit de sélection qui assurent que pendant le fonctionnement normal du ou des composants de circuit (SK1) qui peuvent être testés indépendamment des autres composants de circuit (SK2-SKn), les données (DOUT) qui doivent être effectivement délivrées sur le bus sont délivrées sur le bus, et qui assurent que pendant le test du ou des composants de circuit (SK1) qui peuvent être testés indépendamment des autres composants de circuit (SK2-SKN), des données envoyées sur le ou les composants de circuit (SK1) qui peuvent être testés indépendamment des autres composants de circuit (SK2-SKn) par une unité de test (TE) qui exécute le test sont délivrées sur le bus (BUS).

11. Circuit électrique selon la revendication 10, **caractérisé en ce que** le signal de sortie de la deuxième logique (AND) est le résultat d'une association logique des données (DOUT) qui doivent être délivrées sur le bus en fonctionnement normal et d'un signal de contrôle de test (TESTC), et par lequel l'unité de test (TE) signale qu'elle est en train de tester le ou les composants de circuit (SK1) qui peuvent être testés indépendamment des autres composants de circuit (SK2-SKn).

12. Circuit électrique selon la revendication 10, **caractérisé en ce que** le deuxième circuit de sélection est formé par un multiplexeur qui applique sélectivement les données (DOUT) qui doivent être délivrées en fonctionnement normal sur le bus (BUS) ou un signal de contrôle de test (TESTC) appliqué par l'unité de test (TE) sur le ou les composants de circuit (SK1) qui peuvent être testés indépendamment des autres composants de circuit (SK2-SKn) sur les bornes d'entrée des pilotes de sortie (T) du ou des composants de circuit (SK1) qui peuvent être testés indépendamment des autres composants de circuit (SK2-SKn) et par lesquels le ou les composants de circuit (SK1) qui peuvent être testés indépendamment des autres composants de circuit (SK2-SKn) délivrent sur le bus les données qui doivent être délivrées sur le bus.

13. Circuit électrique selon l'une des revendications 10 à 12, **caractérisé en ce que** le ou les composants de circuit (SK1) qui peuvent être testés indépendamment des autres composants de circuit (SK2-SKn) contiennent un pilote de sortie (T) par lequel le ou les composants de circuit (SK1) qui peuvent être testés indépendamment des autres composants de circuit (SK2-SKn) délivrent sur le bus les données à délivrer sur le bus (BUS) et **en ce qu'**une deuxième logique propre (AND) ou un deuxième circuit de sélection sont prévus pour chaque pilote de sortie (T).

14. Circuit électrique selon la revendication 13, **caractérisé en ce que** le signal de sortie de la deuxième logique (AND) ou du deuxième circuit de sélection est le signal d'entrée du pilote de sortie (T) associé.

15. Circuit électrique selon l'une des revendications 1 à 6 et la revendication 9, **caractérisé en ce que** les données délivrées sur le bus pendant le test du ou des composants de circuit (SK1) qui peuvent être testés indépendamment des autres composants de circuit (SK2-SKn) par le composant de circuit à tester sont appliquées en des emplacements situés entre les bornes de sortie des pilotes de sortie (T) et le bus (BUS).

16. Circuit électrique selon la revendication 15, **caractérisé en ce que** l'application est effectuée par un dispositif de commutation (S).

17. Circuit électrique selon la revendication 16, **caractérisé en ce que** le dispositif de commutation (S) est commandé par une troisième logique (I, NOR).

18. Circuit électrique selon la revendication 17, **caractérisé en ce que** le signal de sortie de la troisième logique (I, NOR) est le résultat d'une association logique entre le signal de libération (EN) et le signal de contrôle de test (TESTC).

19. Circuit électrique selon l'une des revendications 16 à 18, **caractérisé en ce que** lorsqu'il est à l'état passant, le dispositif de commutation (S) relie les emplacements sur lesquels les données à délivrer sur le bus (BUS) doivent être appliquées pendant le test à un point qui présente un potentiel prédéterminé.

20. Procédé de test d'un composant de circuit (SK1) qui est relié à d'autres composants de circuit (SK2-SKn) par un bus (BUS), le composant de circuit à tester pouvant être testé indépendamment des autres composants de circuit,
**caractérisé en ce que**
pendant le test du composant de circuit (SK1) à tester, le composant de circuit (SK1) à tester ne délivre pas de données sur le bus (BUS) ou **en ce qu'**il délivre sur le bus d'autres données que les données (DOUT) qui devraient être délivrées sur le bus en fonctionnement normal, les autres données étant sélectionnées de manière à minimiser la consommation en énergie des pilotes de sortie (T) des composants de circuit (SK1) à tester.

21. Procédé selon la revendication 20, **caractérisé en ce que** les pilotes de sortie (T) des composants de circuit (SK1) à tester et par lesquels ces derniers délivrent sur le bus les données à délivrer sur le bus (BUS) sont désactivés pendant le test du composant.

22. Procédé selon la revendication 21, **caractérisé en ce que** la désactivation des pilotes de sortie (T) est lancée par une unité de test (TE) qui teste le composant de circuit (SK1) testé.

23. Procédé selon les revendications 21 ou 22, **caractérisé en ce que** la désactivation des pilotes de sortie (T) s'effectue en utilisant une première logique (AND2) ou un premier circuit de sélection qui assurent, pendant le fonctionnement normal du composant de circuit (SK1) à tester, que les pilotes de sortie sont commandés en fonction d'un signal de libération (EN) qui est amené aux composants de circuit par un dispositif (BUSCONTROL) de contrôle de bus qui contrôle le bus (BUS) et qui assurent que pendant le test du composant de circuit (SK1) à tester, les pilotes de sortie (T) sont commandés en fonction d'un signal de contrôle de test (TESTC) qui est appliqué sur les composants de circuit (SK1) à tester par l'unité de test (TE) qui exécute le test.

24. Procédé selon la revendication 23, **caractérisé en ce que** le signal de sortie de la première logique (AND2) est le résultat d'une association logique du signal de libération (EN) et du signal de contrôle de test (TESTC).

25. Procédé selon la revendication 23, **caractérisé en ce que caractérisé en ce que** le signal de sortie de la première logique (AND2) est le résultat d'une association logique du signal de libération (EN) et du signal de contrôle de test (TESTC).

26. Procédé selon l'une des revendications précédentes, **caractérisé en ce que** le test du composant de circuit (SK1) est signalé à un dispositif (BUSCONTROL) de commande de bus qui commande le bus (BUS).

27. Procédé selon la revendication 26, **caractérisé en ce que** pendant le test du composant de circuit (SK1), le dispositif (BUSCONTROL) de commande de bus assure que le bus est interrompu par un des autres composants de circuit (SK2-SKn) ou par le dispositif (BUSCONTROL) de commande de bus proprement dit.

28. Procédé selon la revendication 20, **caractérisé en ce que** les données que le composant de circuit (SK1) délivre sur le bus (BUS) pendant qu'il est testé ne se modifient pas ou ne se modifient que rarement.

29. Procédé selon la revendication 28, **caractérisé en ce que** la sélection des données à délivrer sur le bus (BUS) s'effectue en recourant à une deuxième logique (AND) ou à un deuxième circuit de sélection qui assurent que pendant le fonctionnement normal du composant de circuit (SK1) à tester, les données (DOUT) qui doivent être effectivement délivrées sur le bus sont délivrées sur le bus, et qui assurent que pendant le test du composant de circuit (SK1) à tester, des données envoyées sur le composant de circuit (SK1) à tester par une unité de test (TE) qui exécute le test sont délivrées sur le bus (BUS).

30. Procédé selon la revendication 29, **caractérisé en ce que** le signal de sortie de la deuxième logique (AND) est le résultat d'une association logique des données (DOUT) qui doivent être délivrées sur le bus en fonctionnement normal et d'un signal de contrôle de test (TESTC), et par lequel l'unité de test (TE) signale qu'elle est en train de tester le composant de circuit (SK1) à tester.

31. Procédé selon la revendication 29, **caractérisé en ce que** le deuxième circuit de sélection est formé par un multiplexeur qui applique sélectivement les données (DOUT) qui doivent être délivrées en fonctionnement normal sur le bus (BUS) ou un signal de contrôle de test (TESTC) appliqué par l'unité de test (TE) sur le composant de circuit (SK1)à tester sur les bornes d'entrée des pilotes de sortie (T) du composant de circuit (SK1) et par lesquels le composant de circuit (SK1) à tester délivre sur le bus les données qui doivent être délivrées sur le bus.

32. Procédé selon l'une des revendications 29 à 31, **caractérisé en ce que** le composant de circuit (SK1) à tester contient un pilote de sortie (T) par lequel le composant de circuit (SK1) à tester délivre sur le bus les données à délivrer sur le bus (BUS) et **en ce qu'**une deuxième logique propre (AND) ou un deuxième circuit de sélection sont prévus pour chaque pilote de sortie (T).

33. Procédé selon la revendication 32, **caractérisé en ce que** le signal de sortie de la deuxième logique (AND) ou du deuxième circuit de sélection est le signal d'entrée du pilote de sortie (T) associé.

34. Procédé selon l'une des revendications 20 à 25 et 28, **caractérisé en ce que** les données délivrées sur le bus pendant le test du composant de circuit (SK1) par le composant de circuit à tester sont appliquées en des emplacements situés entre les bornes de sortie des pilotes de sortie (T) et le bus (BUS).

35. Procédé selon la revendication 34, **caractérisé en ce que** l'application est effectuée par un dispositif de commutation (S).

36. Procédé selon la revendication 35, **caractérisé en ce que** le dispositif de commutation (S) est commandé par une troisième logique (I, NOR).

37. Procédé selon la revendication 36, **caractérisé en ce que** le signal de sortie de la troisième logique (I, NOR) est le résultat d'une association logique entre le signal de libération (EN) et le signal de contrôle de test (TESTC).

38. Procédé selon l'une des revendications 35 à 37, **caractérisé en ce que** lorsqu'il est à l'état passant, le dispositif de commutation (S) relie les emplacements sur lesquels les données à délivrer sur le bus (BUS) doivent être appliquées pendant le test en un point qui présente un potentiel prédéterminé.
